# EUROPEAN PATENT SPECIFICATION

(11) **EP 3 442 020 B1**
(45) Date of publication and mention of the grant of the patent: **07.10.2020**
(21) Application number: 17769659.8
(22) Date of filing: 31.01.2017
(51) Int. Cl.: H01L 25/07, H01L 25/18

(54) **POWER SEMICONDUCTOR MODULE**
LEISTUNGSHALBLEITERMODUL
MODULE À SEMI-CONDUCTEUR DE PUISSANCE

(30) Priority: 24.03.2016 JP 2016059387
(43) Date of publication of application: 13.02.2019
(73) Proprietor: Hitachi, Ltd., Tokyo 100-8280 (JP)
(72) Inventor: MASUDA Toru, Tokyo 100-8280 (JP)
(74) Representative: Strehl Schübel-Hopf & Partner
(86) International application number: PCT/JP2017/003255
(87) International publication number: WO 2017/163612

(56) References cited:
- WO-A1-2016/009496
- JP-A- H10 308 471
- JP-A- H10 309 073
- JP-A- 2005 026 524
- JP-A- 2007 173 680
- JP-A- 2010 258 135
- JP-A- 2013 033 812
- JP-U- 3 096 721
- US-A1- 2007 145 540
- US-A1- 2007 228 579

## Description

### Technical Field

The present invention relates to a power semiconductor module which is configured by a power transistor such as an insulated gate bipolar transistor (IGBT) and a metal-oxide-semiconductor field-effect transistor (MOSFET) mounted in a semiconductor insulating substrate, and particularly to a power semiconductor module which includes a conductor structure therein.

### Background Art

In a power control and a motor control of industrial machines, electric railway vehicles, automobiles, and electrical appliance, there is used a power semiconductor module in which a plurality of switching devices such as power MOSFETs and IGBTs, and semiconductor device chips such as free-wheeling diodes are integrally mounted as a module. In recent years, gallium nitride (GaN) and silicon carbide (SiC) are used as materials for the power semiconductor. The power semiconductor made of such materials has advantages such as a high switching speed and a wide temperature range of the operation compared to the semiconductor device chip made of silicon (Si). Practically, a GaN or SiC device is small in size. Therefore, in order to form the power semiconductor module satisfying a predetermined rating current, there is a need to arrange a plurality of semiconductor device chips in parallel and to mount the chips in a semiconductor insulating substrate in the module.

In the related art, there is disclosed a technique of arranging the plurality of semiconductor device chips in parallel on the semiconductor insulating substrate in the power semiconductor module, in which a plurality of transistor devices are disposed in parallel with diode devices in one semiconductor insulating substrate (for example, see PTL 1).

In addition, in the related art, there is disclosed a technique of arranging the plurality of semiconductor device chips in parallel on the semiconductor insulating substrate in the power semiconductor module, in which the power semiconductor device chips are disposed to be interposed by a pair (two) of module substrates (semiconductor insulating substrate) (for example, see PTL 2).

In addition, in the related art, there is disclosed a technique of reducing a mutual inductance of two adjacent conductor layers, in which the directions of currents of parts of the two conductor layers are determined as parallel or reverse depending on a direction of a slit pattern disposed in the conductor layer (for example, see PTL 3).

### Citation List

### Patent Literature

PTL 1: JP 2015-142059 A
PTL 2: JP 2014-107506 A
PTL 3: WO 2012/111397

US 2007/145540 A1 discloses a semiconductor module different in configuration to the one of the present invention but including slit patterns for the relaxation of thermal stresses in the layers of its laminate structure, JP H10 308471 A discloses a further semiconductor module related to the one of the present invention.

### Summary of Invention

### Technical Problem

FIG. 4 of PTL 1 is "a top view and a cross-sectional view illustrating a configuration of the power semiconductor module using a conventional arranging method", in which a plurality of transistor devices 5 and a diode device 31 are arranged in parallel in a semiconductor insulating substrate 2. In FIG. 4 of PTL 1, a conductor pattern 3B to connect collector electrodes (or drain electrodes) of the plurality of transistor devices 5 and a cathode electrode of the diode device 31, a conductor pattern 3A to connect an emitter electrode (or source electrode) of the transistor device 5 and an anode electrode of the diode device 31, a conductor pattern 3C to connect a gate electrode of the transistor device 5, and a conductor pattern 3D for a source sense conductor paired up with a gate electrode conductor are arranged in the surface of the semiconductor insulating substrate 2. A ratio of the area occupied by the semiconductor device chip in the semiconductor insulating substrate 2 becomes equal to or less than 50%, and a chip-mount ratio on the semiconductor insulating substrate of the semiconductor device chip is low. As an object, the chip-mount ratio on the semiconductor insulating substrate is improved, for example, by reducing or transferring a pattern area of the conductor pattern 3A, the conductor pattern 3C, and the conductor pattern 3D onto other semiconductor insulating substrate.

PTL 2 discloses a configuration in which the power semiconductor device chip is interposed by a pair of module substrates. Herein, the module substrate has the same function as the semiconductor insulating substrate 2 disclosed in PTL 1. In PTL 1, a conventional example is described in which the semiconductor insulating substrate 2 is configured by one. On the other hand, in PTL 2, a pair (that is, two) of module substrates are used to be connected to the power semiconductor device chip, and also the conductor pattern is disposed in a rear surface of the module substrate. In order to improve the chip-mount ratio on the semiconductor insulating substrate of the power semiconductor device chip, in PTL 2, the conductor pattern connected to the power semiconductor device chip is arranged in the conductor layer on the plurality of module substrates so as to improve the chip-mount ratio on the semiconductor insulating substrate of the power semiconductor device chip. In other words, according to PTL 2, there is an advantage that the chip-mount ratio on the semiconductor insulating substrate of the power semiconductor device chip can be improved while the area of the substrate to be mounted in the power semiconductor module is reduced.

However, as an example of a built-in structure of the power semiconductor module, the conductor pattern is configured such that a distance between two different patterns approaches each other within several mm (for example, 1.5 mm), and similarly the conductor patterns of the rear surfaces of insulating layers of the substrates also approach each other within several mm (for example, 0.7 mm) in many cases. Therefore, a current flowing in the conductor pattern and an applied voltage are transferred to the current and the voltage of the other conductor pattern as noises so as to cause degradation in the electrical operation of the power semiconductor module.

In PTL 3, the directions of currents of parts of the two adjacent conductor layers are determined by a longitudinal direction of the slit pattern arranged in the conductor layer, and a value of a mutual inductance M generated by a magnetic coupling between the two conductor layers is set negative by setting the directions of the currents of the two conductor layers to flow in parallel or reverse. With this configuration, the mutual inductance M of the two adjacent conductor layers can be effectively reduced. The invention of the related art actively uses the magnetic interference which is generated between the two adjacent conductor layers, but it clearly fails to reduce noises generated between the two conductor layers or the adjacent conductor patterns.

As shown in the citation of PTLs 1 to 3, a scheme of improving the chip-mount ratio on the semiconductor insulating substrate of the power semiconductor device chip is already clear, but a scheme of reducing noises generated between the conductors at the same time is still unclear.

Therefore, the inner structure of the power semiconductor module is needed to be made compact to improve the chip-mount ratio on the semiconductor insulating substrate of the power semiconductor device chip, and at the same time the noise interference generated between the plurality of conductor patterns connected to the power semiconductor device chip is necessary to be reduced.

More specifically, the following points are the problems. In the inner conductor structure of a power semiconductor module, a laminated conductor structure in which two or more conductor layers are approached in plane is effective to provide a compact power semiconductor module by increasing the chip-mount ratio on the semiconductor insulating substrate of the plurality of semiconductor device chips. However, the structure causes a larger interference between the close conductor layers, and increases noises in electrical characteristics. In order to solve the problems, there is a need to provide a structure which can reduce noises generated between the conductor patterns even with a compact inner structure of the power semiconductor module.

### Solution to Problem

To solve the above problems, the present invention suggests the power semiconductor module defined in Claim 1. Further advantageous features are set out in the dependent claims.

### Advantageous Effects of Invention

According to the invention, it is possible to make the inner structure of the power semiconductor module compact to improve the chip-mount ratio on the semiconductor insulating substrate of the power semiconductor device chip, and at the same time to reduce the noise interference generated between the plurality of conductor patterns connected to the power semiconductor device chip.

### Brief Description of Drawings

[FIG. 1] FIG. 1 is a top view and a cross-sectional view illustrating a circuit board of a power semiconductor module according to a first embodiment of the invention.
[FIG. 2a] FIG. 2a is a cross-sectional view illustrating an example of main parts of the power semiconductor module according to the first embodiment of the invention.
[FIG. 2b] FIG. 2b is a top view illustrating an example of the main parts of the power semiconductor module according to the first embodiment of the invention.
[FIG. 3] FIG. 3 is a diagram illustrating an example of the circuit board of the power semiconductor module according to the related art.
[FIG. 4a] FIG. 4a is a diagram schematically illustrating an example of a laminated conductor structure of the power semiconductor module according to the first embodiment of the invention.
[FIG. 4b] FIG. 4b is a cross-sectional view illustrating the structure of FIG. 4a taken along line segment C-C', in which no slit pattern is provided.
[FIG. 4c] FIG. 4c is a cross-sectional view illustrating the structure of FIG. 4a taken along line segment C-C', in which a slit pattern is provided.
[FIG. 4d] FIG. 4d is a characteristic diagram illustrating a relation between interconductor gaps Sa and Sb and an interconductor coupling coefficient K in the structure of FIGS. 4b and 4c.
[FIG. 5a] FIG. 5a is a top view schematically illustrating another example of the laminated conductor structure of the power semiconductor module according to the first embodiment of the invention.
[FIG. 5b] FIG. 5b is a cross-sectional view illustrating the structure of FIG. 5a taken along line segment D-D'.
[FIG. 5c] FIG. 5c is diagram illustrating a calculation result representing a relation between a ratio Sd/Sc of the slit pattern in the structure of FIGS. 5a and 5b and a parasitic capacitance value of the conductor patterns 3a and 4a.
[FIG. 6] FIG. 6 is a circuit diagram illustrating an equivalent circuit of the power semiconductor module according to the first embodiment of the invention.
[FIG. 7] FIG. 7 is a top view illustrating the circuit board of the power semiconductor module according to a second embodiment of the invention.

### Description of Embodiments

As described above, a power semiconductor module of the invention includes at least one first circuit board which is configured by a plurality of semiconductor device chips disposed in a conductor pattern formed in a main surface of a first semiconductor insulating substrate, and at least one second circuit board which is configured by another conductor pattern formed on both surfaces of a second semiconductor insulating substrate different from the first semiconductor insulating substrate. The semiconductor device chip of the first circuit board is connected to the other conductor pattern of the second circuit board. The second circuit board includes a slit pattern which is formed by a plurality of hole-shaped slits on the other conductor pattern.

In the configuration of the power semiconductor module, for example, the plurality of semiconductor device chips includes at least one switching device. The conductor pattern of the first circuit board is configured to include a first conductor pattern which is formed on the first semiconductor insulating substrate, and a second conductor pattern which is formed in a region different from the first conductor pattern on the first semiconductor insulating substrate to be electrically insulated from the first conductor pattern. The first conductor pattern includes a first power feeding point at one end of the first conductor pattern to feed a potential to the first conductor pattern, and is configured to connect a first electrode terminal of the at least one switching device onto the first conductor pattern. The second conductor pattern is provided near the first power feeding point, and includes a second power feeding point to feed a potential different from the first conductor pattern and a third power feeding point to feed a potential different from the first conductor pattern to the second circuit board. The other conductor pattern of the second circuit board is configured to include a third conductor pattern which is disposed in one surface on the second semiconductor insulating substrate, and a fourth conductor pattern and a fifth conductor pattern which, on the second semiconductor insulating substrate, are disposed on a surface opposite to the surface where the third conductor pattern is disposed. The second circuit board is configured to insulate the third conductor pattern from the fourth conductor pattern and the fifth conductor pattern by the second semiconductor insulating substrate. The second circuit board is disposed such that the third conductor pattern of the second circuit board faces the first conductor pattern of the first circuit board. The third conductor pattern is connected to a second electrode terminal of the at least one switching device. The fourth conductor pattern is connected to the second electrode terminal of the at least one switching device. The fifth conductor pattern is connected to the third electrode terminal of the at least one switching device. The second conductor pattern is connected to the third conductor pattern of the second circuit board. The first conductor pattern is connected to a first module electrode terminal of the power semiconductor module by the first power feeding point. The second conductor pattern is connected to a second module electrode terminal of the power semiconductor module by at least any one of the second power feeding point and the third power feeding point. The fourth conductor pattern includes a fourth power feeding point to feed a potential to the fourth conductor pattern, and is connected to a third module electrode terminal of the power semiconductor module by the fourth power feeding point. The fifth conductor pattern includes a fifth power feeding point to feed a potential to the fifth conductor pattern, and is connected to a fourth module electrode terminal of the power semiconductor module by the fifth power feeding point. In the slit pattern, at least any one of the third conductor pattern of the second circuit board, the fourth conductor pattern, and the fifth conductor pattern is formed on one conductor pattern.

Hereinafter, embodiments of the invention will be described using the drawings.

### First embodiment

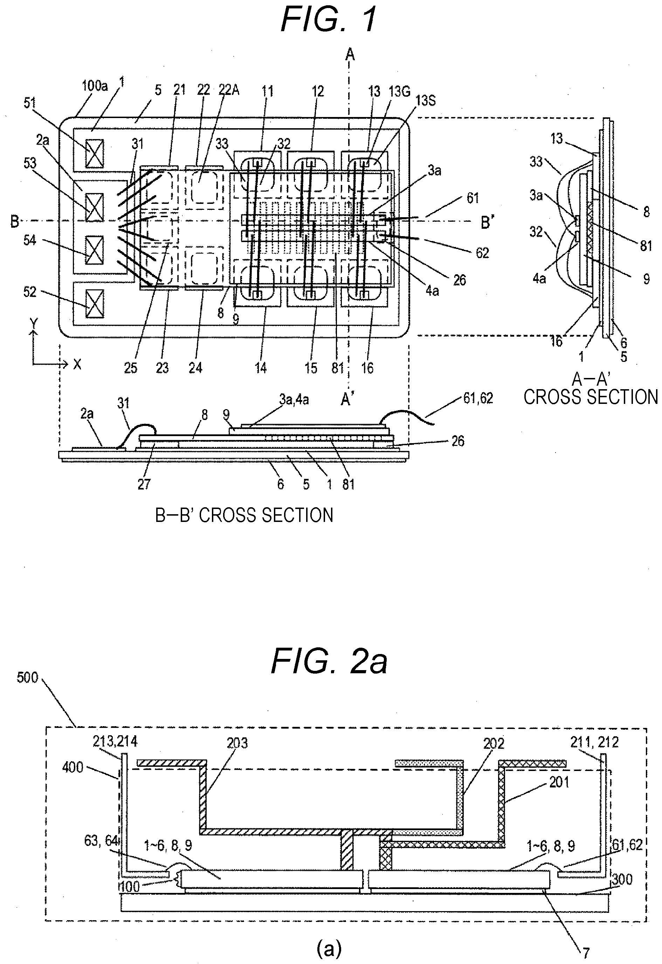

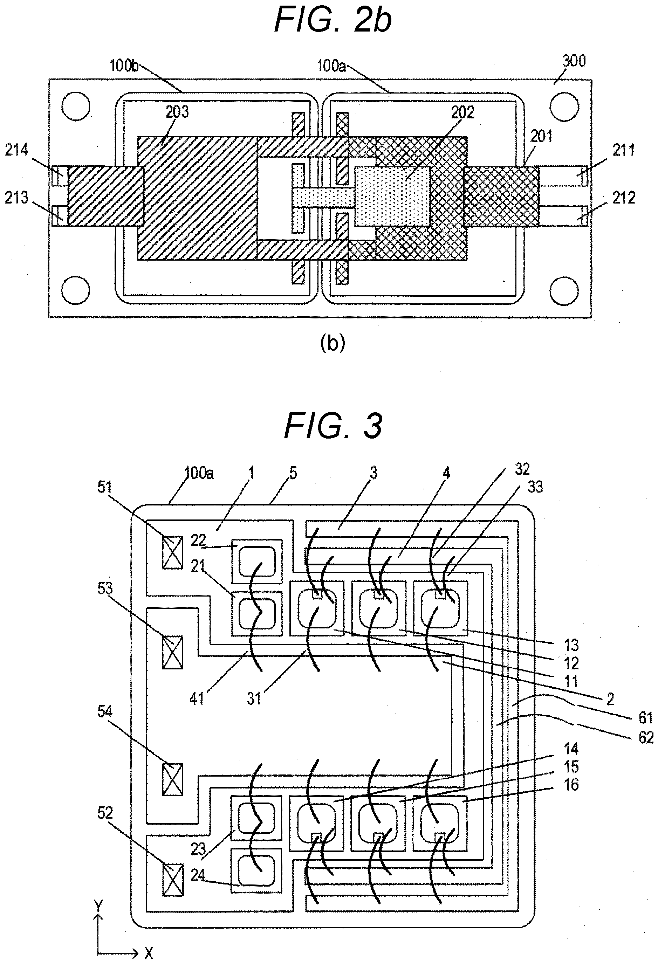

A configuration of a power semiconductor module according to a first embodiment of the invention will be described using FIG. 1. FIG. 1 illustrates a configuration of a circuit board 100 in which a plurality of components are stacked, and the component layout in the lower layer (not illustrated) will be depicted with a dotted line for convenience' sake. In a circuit board 100a, the high-potential conductor pattern 1 and the low-potential conductor pattern 2a are disposed similarly to FIG. 3.

In the conductor pattern 1, cathode terminals of semiconductor diode devices 21 to 24 are electrically connected, collector terminals or drain terminals 11D to 16D of switching devices 11 to 16 made of semiconductor are electrically connected, and power feeding positions 51 and 52 are disposed for the connection to an external lead terminal 201.

In the conductor pattern 2a, power feeding positions 53 and 54 for the connection to an external lead terminal 203 and a bonding position for the connection to a conductor plate 8 by a bonding wire are provided.

The conductor plate 8 forms a laminated conductor 71 together with an insulating plate 9 (described below) and the conductor patterns 3a and 4a, and anode terminals of the diode devices 21 to 24 and the collector terminals or the drain terminals of the switching devices 11 to 16, and gate terminals 11G to 16G and source (sense) terminals 11S to 16S of the switching devices 11 to 16 are connected thereto. In the conductor plate 8, anode terminals 21A to 24A of the diode devices 21 to 24 are electrically connected by soldering or sintering, the collector terminals or the drain terminals of the switching devices 11 to 16 are also electrically connected by the same method as the diode device, and the conductor pattern 2a is connected to the external lead terminal 203 through a bonding wire.

The insulating plate 9 is disposed in the upper surface of the conductor plate 8, and is insulated from the conductor plate 8 and the conductor patterns 3a and 4a.

The patterns 3a and 4a for controlling signals of a switching semiconductor device chip formed of the conductor pattern each are electrically connected to the gate terminal of the switching device through bonding wires 31 and 32 from the source (sense) terminal, and connected to a control signal generating circuit outside the module through bonding wires 61 and 62.

FIGS. 2a and 2b are diagrams illustrating an example of a configuration of main parts of the power semiconductor module according to the embodiment. FIG. 2a is a cross-sectional view of the power semiconductor module. FIG. 2b is a top view of the power semiconductor module. In FIGS. 2a and 2b, the power semiconductor module 500 is configured by a case 400, a metal base 300, the external lead terminals 201 to 203, control signal terminals 211 to 214, the circuit board 100, and a soldering layer 7.

The case 400 determines the outer appearance of the module, and is made of an insulating resin. In the following description, the description of the case will be omitted if not needed.

The metal base 300 determines the outer appearance of the module together with the case 400, is made of a metal material, and abuts on a heat sink to serve as a passage through which heat of one or more circuit boards 100 bonded by the soldering layer 7 is radiated.

The external lead terminals 201 to 203 are terminals to connect the metal conductor pattern on the circuit board 100 and the main circuit outside the module, and serve as an input/output passage of an energizing current of the module.

The control signal terminals 211 to 214 are terminals to electrically connect the metal conductor pattern on the circuit board 100 and the control signal generating circuit outside the module through the bonding wires 61 to 64, and serve as a passage for the control signal of the switching device in the module.

The circuit board 100 is configured by the metal conductor patterns 1 to 4, a semiconductor insulating substrate 5, and the metal conductor pattern 7. The number of circuit boards 100 used in the power semiconductor module is determined according to a function which is determined by the rating current and the metal conductor pattern.

The soldering layer 7 is used to mechanically and electrically connect the circuit board 100 and the metal base 300.

In FIGS. 2a and 2b, the power semiconductor module is configured using two circuit boards 100a and 100b. The external lead terminal 201 is connected to the conductor pattern which becomes a high potential of the circuit board 100a. The external lead terminal 202 is connected to the conductor pattern which becomes a low potential of a circuit board 100b. The external lead terminal 203 serves to connect the conductor pattern which becomes a low potential of the circuit board 100a and the conductor pattern which becomes a high potential of the circuit board 100b. Herein, in the circuit board 100a and 100b, positions where the external lead terminals are connected to the conductor patterns of the high and low potentials are disposed within a range causing no problem in mounting technology and in insulation design. With this configuration, a loop area of the passage where the current flows from the high-potential conductor pattern to the low-potential conductor pattern is extremely reduced, and an inductance generated in a current passage is suppressed low.

Herein, an example of the related art will be described for the comparison to the invention. FIG. 3 illustrates a mounting example of the related art of the metal conductor pattern and the semiconductor device chip of the circuit board 100a. The circuit board is configured by the high-potential conductor pattern 1, the low-potential conductor pattern 2, control signal patterns 3 and 4 of the switching semiconductor device chip, the semiconductor diode devices 21 to 24 and the switching devices 11 to 16, and the bonding wires 31 to 33, and 41 for connecting the semiconductor device chip.

In the conductor pattern 1, the cathode terminals of the semiconductor diode devices 21 to 24 are electrically connected, the collector terminals or the drain terminals of the semiconductor switching devices 11 to 16 are electrically connected, and the power feeding positions 51 and 52 are disposed to connect the external lead terminal 201.

In the conductor pattern 2, the anode terminals of the diode devices 21 to 24 are electrically connected through the bonding wire 41, the collector terminals or the drain terminals of the switching devices 11 to 16 are electrically connected through the bonding wire 31, and the power feeding positions 53 and 54 are disposed to connect the external lead terminal 203.

The control signal pattern 3 of the switching semiconductor device chip is electrically connected to the gate terminal of the switching device through the bonding wire 32, and the control signal generating circuit outside the module is connected through the bonding wire 61.

The control signal pattern 4 of the switching semiconductor device chip is electrically connected to the source terminal of the switching device through the bonding wire 33, and the control signal generating circuit outside the module is connected through the bonding wire 62.

The power feeding positions 51 and 52 of the external lead terminal and the power feeding positions 51 and 52 are disposed closely in order to reduce the inductance of the passage where the current flows in the circuit board 100a.

The power semiconductor module of the invention illustrated in FIGS. 2a and 2b and the power semiconductor module according to the related art illustrated in FIG. 3 each are a half-bridge circuit of which the upper arm is configured by the circuit board 100a and the lower arm is configured by the circuit board 100b. The external lead terminal 201 serves as a main terminal on a side near the high potential, the external lead terminal 202 serves as a main terminal on a side near the low potential, and the external lead terminal 203 serves as a main terminal of an intermediate potential.

However, there is a problem to be solved in the circuit board 100a in the configuration of the related art illustrated in FIG. 3. The problem will be described below. In the circuit board 100a illustrated in FIG. 3, power semiconductor device chips 11 to 16 are mounted on the conductor pattern 1, and the conductor patterns 2 to 4 connected to the gate and source terminals of the semiconductor device chip are disposed on the same plane as the conductor pattern 1. The conductor patterns 1 and 2 each are required to be formed extremely wide in order to reduce a parasitic inductance of the passage so as to cause the drain current and a source current of the power flow. In addition, the gate terminal wire and the source (sense) terminal wire of the power semiconductor device chip tend to be long in order to connect a plurality of devices. For example, when the size of the circuit board 100a in an X direction is set to 55 mm and the size in a Y direction is set to 50 mm, the lengths of the conductor patterns 3 and 4 are set to about 100 mm, the parasitic inductance generated in these conductor patterns is set to 2 mm wide in proportion to the length. In a case where the thickness of the conductor pattern is extremely small with respect to the width, the parasitic inductance is increased to 100 nH. In this way, the conductor patterns 1 and 2 are necessary to be formed wide, and also the conductor patterns 3 and 4 are inevitably made long in order to connect the plurality of devices. Therefore, in a case where the conductor pattern group is disposed in the same plane on the circuit board 100a, the area of the conductor pattern 1 to mount the semiconductor device chip becomes small, and a chip-mount ratio on the semiconductor insulating substrate of the power semiconductor device chip with respect to the circuit board becomes low. As described above, when the size of the circuit board 100a in the X direction is set to 55 mm, and the size in the Y direction is 50 mm, a ratio occupied by the power semiconductor device chip in the area is about 15%.

The structure of the circuit board in the related art where the conductor pattern illustrated in FIG. 3 is disposed on the same plane has the following problems 1) and 2).
1) The chip-mount ratio on the semiconductor insulating substrate of the power semiconductor device chip is low, and a number of devices are hardly mounted.
2) In a case where the number of devices is increased, the length of the conductor pattern to connect the gate terminal and the source (sense) terminal becomes long to occupy an area, and the parasitic inductance becomes large.

The description will be given about that the invention solves the above problems 1) and 2).

The effect of the power semiconductor module according to the embodiment will be described using FIG. 1.

With the structure illustrated in FIG. 1, it is possible to improve the chip-mount ratio on the semiconductor insulating substrate of the power semiconductor device chip. On an assumption that the dimensions of the power semiconductor device chips of both of the diode device and the switching device described in FIG. 3 as the related art are the same as in the structure of the invention illustrated in FIG. 1, the external dimension of the circuit board 100a can be minimized to 55 mm in the X direction and 32 mm in the Y direction. The structure is equivalent to the improvement of the chip-mount ratio on the semiconductor insulating substrate of the power semiconductor device chip, and the ratio can be set to 23% and about 1.5.

Next, the description below will be given about that an influence of noises due to a magnetic and electric interference generated between the close conductor patterns, which is a problem to be solved by the invention.

FIG. 1 illustrates a method of reducing the interference noises generated between these conductors, focusing on a laminated conductor structure 71 which is introduced to improve the chip-mount ratio on the semiconductor insulating substrate of the power semiconductor chip (that is, the conductor plate 8 and the conductor patterns 3a and 4a).

The interference noises are caused by both of a magnetic coupling and an electric coupling between two conductors which are close through an insulating layer. In the case of the laminated conductor structure 71, the interference noises are generated between the conductor plate 8 and the conductor patterns 3a and 4a which are close through the insulating plate 9.

The magnetic coupling is caused by the mutual inductance M generated between the conductor plate 8 and the conductor patterns 3a and 4a. A change of the source currents of the switching devices 11 to 16 which flow in the conductor plate 8 is superimposed on the gate terminal current or the source (sense) terminal current which flow in the conductor patterns 3a and 4a depending on the magnitude of the mutual inductance M. The noises are generated in the voltage between the gate terminal and the source (sense) terminal which dominantly affect on the characteristics of the switching devices. With the noise voltage, there is a possibility to cause an abnormal operation that a normally disconnected (off) switching device is temporally conducted (on). Therefore, reducing the mutual inductance M, in other words reducing a coupling coefficient is essential to reduce the interference noises.

As a cause of the electric coupling, there is a capacitance between two target conductors. In the case of the laminated conductor structure 71, the parasitic capacitance generated between the conductor plate 8 and the conductor pattern 3a close through the insulating plate 9, and between the conductor plate 8 and the conductor pattern 4a act as causes. The parasitic capacitance is reversely proportional to the thickness of the insulating plate 9, and proportional to the area of the conductor patterns 3a and 4a. Herein, it will be assumed that the area of the conductor plate 8 is sufficiently wide with respect to the conductor patterns 3a and 4a. As described above, there is a need to reduce the parasitic inductance by widening the width of the conductor plate 8 where the source currents of the switching devices 11 to 16 and the anode currents of the diode devices 21 to 24 flow. Therefore, the assumption is practical. There is a need to consider a countermeasure to effectively reduce the area of the conductor plate 8 facing the conductor patterns 3a and 4a in order to reduce the parasitic capacitance.

In the laminated conductor structure 71 according to the invention, the magnetic interference and the electric interference generated between the conductor plate 8 and the conductor patterns 3a and 4a are reduced at the same time by providing a plurality of slit patterns 81 in the conductor plate 8. As illustrated in FIG. 1, the plurality of slit patterns 81 is provided in the conductor plate 8, the longitudinal direction thereof is arranged to intersect with the longitudinal direction of the conductor patterns 3a and 4a. Then, the plurality of slit patterns are arranged in parallel in the longitudinal direction of the conductor patterns 3a and 4a, and the plurality of slit patterns are disposed in a constant density within a range where the conductor patterns 3a and 4a are projected to the conductor plate 8. The length in the longitudinal direction of the slit pattern is selected arbitrarily within a range in which the slit pattern does not reach a collector electrode or a drain electrode of the switching devices 11 to 16 connected to the conductor 8.

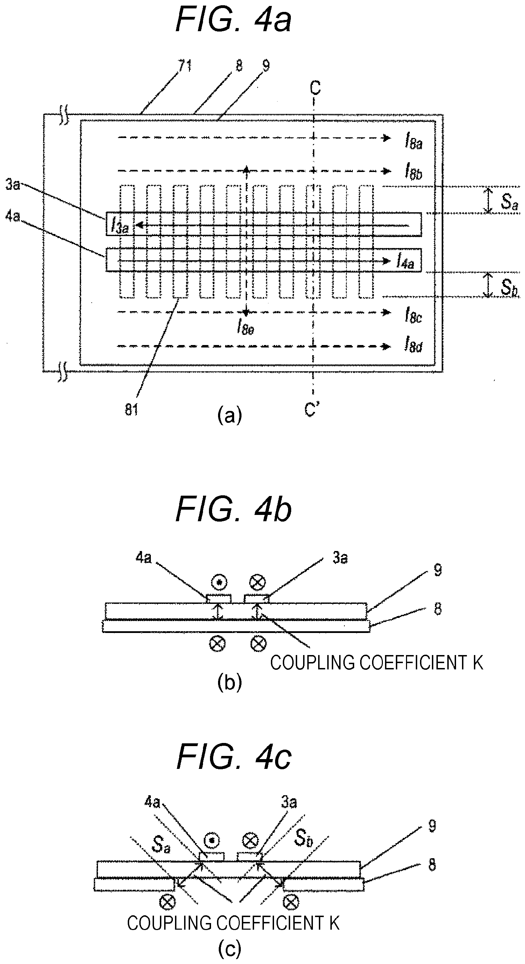

The effect of the plurality of slit patterns 81 disposed in the laminated conductor structure 71 will be described below. FIG. 4a illustrates a diagram schematically illustrating the laminated conductor structure 71 which is configured by the conductor plate 8, the insulating plate 9, and the conductor patterns 3a and 4a. The currents flowing in the conductor plate 8 are depicted with dotted lines I8a to I8e, and the currents flowing in the conductor patterns 3a and 4a are denoted with I3a and I4a. With the plurality of slit patterns, it can be seen that there is no parallel current near the currents I3a and I4a, the currents I8b and I8c are separated from each other by a distance Sa which is determined by the length of the slit in a longitudinal direction. In addition, in a case where the current I8e flows between the slit patterns 81, the direction of the current is orthogonal to the direction of the currents I3a and I4a which flow in the conductor patterns 3a and 4a. Therefore, the magnetic coupling is small enough to be ignored.

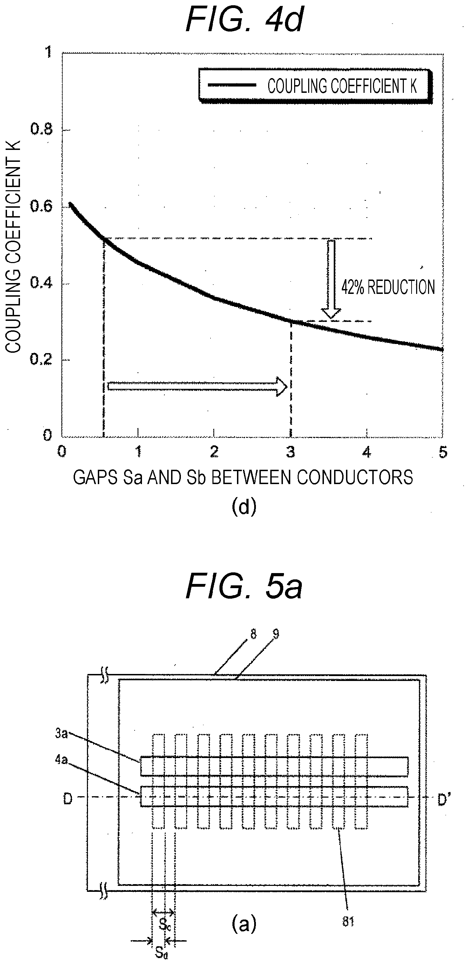

The cross-sectional structure of FIG. 4a taken along line segment C-C' is illustrated in FIGS. 4b and 4c. FIG. 4b is a cross-sectional view in a case where there is no slit pattern 81. FIG. 4c is a cross-sectional view in a case where the slit pattern 81 is applied (that is, a case where the slit pattern 81 is included). In the drawing, "Sa" represents a gap (that is, a shortest distance) between the conductors 4a and 8, "Sb" represents a gap (that is, a shortest distance) between the conductors 3a and 8. In a case where there is no slit pattern of FIG. 4b, the current flows to the just below conductor plate 8 through the insulating plate 9 with respect to the conductor patterns 3a and 4a, and thus the magnetic coupling coefficient K is relatively large. On the other hand, in a case where the slit pattern 81 of FIG. 4c is applied, the conductor plate 8 is away from the conductor patterns 3a and 4a. Therefore, the coupling coefficient K is suppressed to a small value, and the interference noises generated between the conductor patterns 3a and 4a and the conductor plate 8 can be reduced. The relation is quantitatively illustrated in FIG. 4d. FIG. 4d is a characteristic diagram illustrating a relation between the interconductor gaps Sa and Sb and the interconductor coupling coefficient K. It is assumed that the width of the conductor patterns 3a and 4a is set to 2 mm and is thin in such a degree that can be ignored. The horizontal axis represents the shortest gap between the conductor patterns 3a and 4a and the conductor plate 8, and shows a calculation result of the coupling coefficient K between conductors disposed in the gap. For example, in a case where there is no slit pattern, and the thickness of the insulating plate 9 is set to 0.5 mm, the value becomes the shortest gap between the conductors, and the coupling coefficient K becomes about 0.52. In a case where the slit pattern 81 is introduced and the shortest distance between the conductor is extended up to 3 mm, the coupling coefficient K becomes 0.3, and the magnetic coupling can be reduced by about 42%. In this way, with the introduction of the plurality of slit patterns 81, the distance of the portion where the parallel current flows can be large between the conductors from which the interference noises are reduced, and the magnetic coupling can be surely reduced.

In addition, the length in the longitudinal direction of the conductor patterns 3a and 4a can be made short compared to the configuration of FIG. 3 which is the configuration of the circuit board 100 of the related art. In the configuration of FIG. 3, all the conductor patterns to be connected to the power semiconductor device chips are need to be disposed on the same surface of the insulating plate 5, the flexibility in shape of the conductor patterns 3 and 4 to be connected to the plurality of power semiconductor device chips is low, and the distance becomes long. The conductor patterns 3a and 4a on the laminated conductor structure 71 illustrated in the first embodiment are disposed in the surface on the insulating plate 9, but the power semiconductor device chips are not disposed on the surface. Therefore, the conductor shape is less restricted. Since the flexibility in shape is increased even though the layout range of the slit pattern is limited to the conductor plate 8 in order to reduce the above-described magnetic coupling, it is possible to shorten the distance itself. Therefore, in the laminated conductor structure 71 of the first embodiment, it can be said that the noise interference is effectively reduced even in view of shortening the conductor patterns 3a and 4a which are affected by the noise interference.

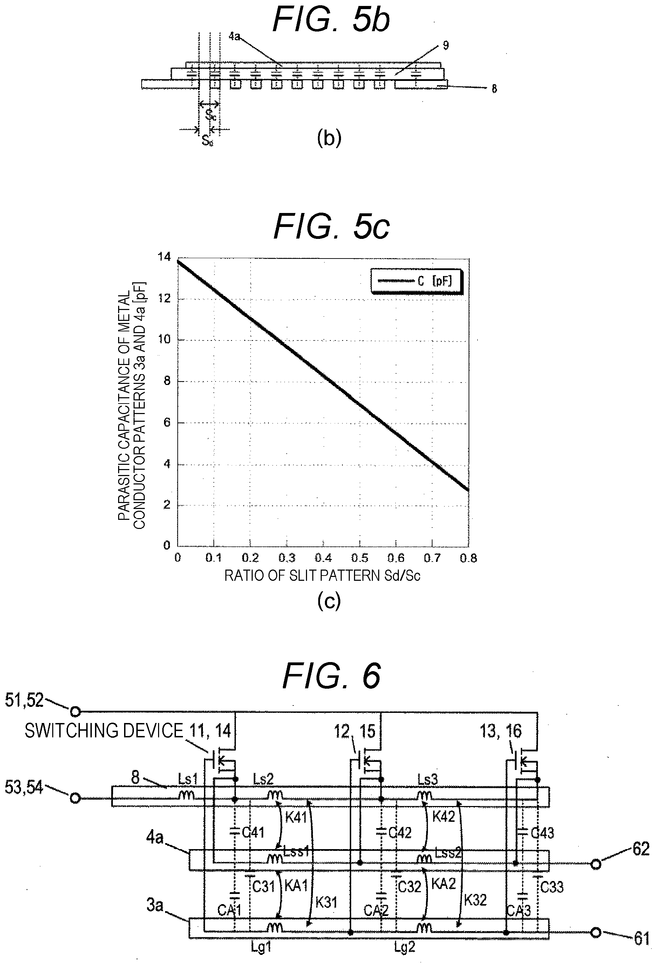

Next, the reduction in electric coupling will be described using FIGS. 5a, 5b, and 5c. FIG. 5a is a top view schematically illustrating the structure of the laminated conductor structure 71, and FIG. 5b is a cross-sectional view illustrating a cross-sectional structure taken along line segment D-D' in FIG. 5a. In FIGS. 5a and 5b, a layout pitch distance of the plurality of slit patterns 81 is set to "Sc", a slit pattern width (a length in a lateral direction) in the pitch distance Sc is set to "Sd". The parasitic capacitance which is generated between the conductor patterns 3a and 4a and the conductor plate 8 through the insulating plate 9 shows a distribution as illustrated in the cross-sectional view of FIG. 5b in a case where there is a slit pattern. A parasitic capacitance value varies depending on a ratio of the slit pattern width Sd to the layout pitch distance Sc with reference to the parasitic capacitance value in a case where there is no slit pattern. For example, FIG. 5c illustrates a calculation result showing the relation between the ratio Sd/Sc of the slit pattern and the parasitic capacitance value of the conductor patterns 3a and 4a in a case where it is assumed that the length and the width of the conductor patterns 3a and 4a are 25 mm and 2 mm respectively, and the insulating plate 9 made of AlN is 0.5 mm thick. As illustrated in the drawing, the parasitic capacitance value is reduced as the ratio Sd/Sc is increased, and the capacitance value is reduced to the half in a case where the ratio Sd/Sc is 0.5 compared to a case where there is no slit pattern.

FIG. 6 is a circuit diagram illustrating an equivalent circuit of the power semiconductor module according to the embodiment. The effect of the plurality of slit patterns 81 disposed in the laminated conductor structure 71 is shown by the equivalent circuit of FIG. 6. From the description of the circuit board 100 of FIG. 1, the parasitic elements other than the laminated conductor structure 71 and the conductor pattern 1 are not illustrated. Further, the drawing illustrates the equivalent circuit only for the switching devices 11 to 16 related to the conductor patterns 3a and 4a of the power semiconductor device chip. The conductor pattern 3a is a conductor pattern to connect a gate electrode of the power semiconductor device chip, and the parasitic inductance is denoted by Lg1 and Lg2. The conductor pattern 4a is a source sense conductor to connect a source electrode of the power semiconductor device chip, and the parasitic inductance is denoted by Lss1 and Lss2. The conductor plate 8 is a conductor which connects the source electrode of the power semiconductor device chip and through which the source current flows. The parasitic inductance is denoted by Ls1, Ls2, and Ls3. In addition, the magnetic coupling between the conductors is denoted by the coupling coefficient K between the parasitic inductances, the coupling between the conductor pattern 3a and the conductor plate 8 is denoted by K31 and K32, the coupling between the conductor pattern 4a and the conductor plate 8 is denoted by K41 and K42, and the coupling between the conductor patterns 3a and 4a is denoted by KA1 and KA2.

Further, the electric coupling is equivalently expressed by the parasitic capacitance, the parasitic capacitance between the conductor pattern 3a and the conductor plate 8 is set to C31, C32, and C33, the parasitic capacitance between the conductor pattern 4a and the conductor plate 8 is set to C41, C42, and C43, and the coupling between the conductor patterns 3a and 4a is set to CA1, CA2, and CA3. With the effect of the plurality of slit patterns 81 disposed in the laminated conductor structure 71, the coupling coefficients K31, K32, K41, and K42 may be reduced by 42% for example as illustrated above, and at the same time the parasitic capacitances C31, C32, C41, and C42 may be reduced to the half for example . Therefore, this equivalent circuit can also show that the electric coupling between the conductor plate 8 and the conductor patterns 3a and 4a can be reduced, and the noise interference can be surely reduced.

Further, the invention is not limited to the above embodiments, and various modifications can be made. For example, the embodiments are described in a clearly understandable way for the invention, and thus the invention is not necessarily to provide all the configurations described above. In addition, some configurations of a certain embodiment may be replaced with the configurations of another embodiment, and the configuration of the other embodiment may also be added to the configuration of a certain embodiment. Furthermore, additions, omissions, and substitutions may be made on some configurations of each embodiment using other configurations.

For example, even in a case where the MOS field effect transistor (MOSFET) used as the switching device in the embodiment is replaced with any one of a unipolar device of a junction field effect transistor (J-FET) and a bipolar device such as an isolated gate bipolar transistor (IGBT) and the drain is changed into the collector, the source into the emitter, and the gate into the base among the functions of terminal, the effect of the invention is not changed. In addition, it is a matter of course that the effect of the invention is not changed even if any one of a PN-junction diode and a schottky junction (SB) diode is used as the diode device.

In addition, the embodiment may employ support chips 25 and 26 which are made of semiconductor to bond the wires. The support chips have the same height as the semiconductor chips 11 to 16 and 21 to 24, and the electrodes are disposed on both surfaces. Therefore, it is possible to connect the support chips to the conductor pattern 1 and the conductor plate 8 in the same connection method as the semiconductor chips 11 to 16 and 21 to 24. However, the electrodes on both surfaces are necessarily insulated with a predetermined breakdown voltage of the module. With the application of the support chips, the support chips are disposed at connection points of the bonding wires to the conductor plate 8 and connection points of the bonding wires to the semiconductor patterns 3a and 4a on back surfaces. With this configuration, when bonding the wires, the connection portions of the bonding tool are fixed regardless of the vibration of the tool. Therefore, according to the configuration, it is possible to prevent a defect that the vibration of the insufficiently fixed tool is dispersed, so that it is possible to securely connect the bonding wire. The configuration is especially effective in a situation that the connection portions of the bonding tool are easily affected by the vibration influence. However, it is a matter of course that the support chip may be omitted in a case where the situation that the connection portions are hardly affected by the vibration of the tool is secured by any other component.

Hitherto, according to the embodiment, it is possible to provide the power semiconductor module which can improve the chip-mount ratio on the semiconductor insulating substrate of the power semiconductor device chip, and reduce the noise interference between the plurality of conductor patterns which are connected to the power semiconductor device chip.

### Second embodiment

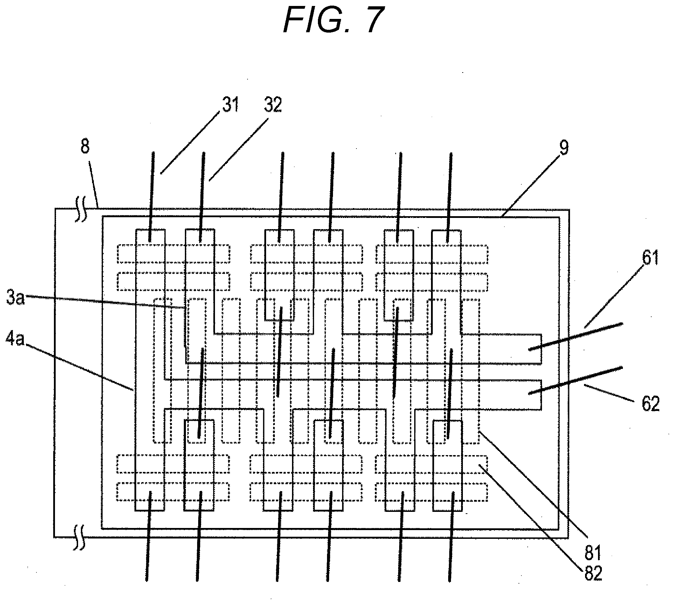

FIG. 7 illustrates an example of a circuit board of the power semiconductor module according to a second embodiment of the invention, which is configured by the conductor plate 8, the insulating plate 9, and the conductor patterns 3a and 4a for the control signals of the switching semiconductor device chips.

The embodiment is a modification of the first embodiment. In the embodiment, the conductor patterns 3a and 4a each are configured by a plurality of sides crossing at a right angle. This configuration of the embodiment is different from that of the first embodiment, but the other configurations are common.

With this configuration, it is possible to shorten the length of the bonding wire to connect the conductor pattern 3a and the gate electrode of the switching semiconductor device chip, and the length of the bonding wire to connect the conductor pattern 4a and the source electrode of the switching semiconductor device chip. Therefore, it is possible to reduce a possibility of resonance in the passages of the gates of the plurality of switching semiconductor device chips.

If the lengths of the conductor patterns 3a and 4a are lengthened as described in the embodiment, noises from voltage and current of the conductor 8 serving as the front and rear surfaces are easily introduced through the insulating plate 9 in the case of the related art. However, in the embodiment, the slit patterns are disposed in the conductor plate 8 to be orthogonal to the respective sides of the conductor patterns 3a and 4a in order to reduce the noises. With this configuration, the length of the bonding wire is shortened to reduce the possibility of resonance in the gate passage of the plurality of switching semiconductor device chips, and also the noises from voltage and current of the conductor 8 can be reduced.

### Reference Signs List

1 to 2, 6 conductor pattern
3 to 4 conductor pattern for control signal of switching semiconductor device chip
5 semiconductor insulating substrate
7 soldering layer
8 conductor plate
9 insulating plate
11 to 16 switching device
21 to 24 diode device
25 to 26 support chip for wire bonding
31 to 33, 41, 61 to 64 bonding wire
51 to 52 power feeding positions for connection with external lead terminal 201
53 to 54 power feeding positions for connection with external lead terminal 203
81, 82 slit pattern
100, 100a, 100b circuit board
201 to 203 external lead terminal
211 to 214 control signal terminal
300 metal base 300
400 case 400
500 power semiconductor module
K, K31, K32, K41, K42, KA1, KA2 coupling coefficient
C31 to C33, C41 to C43, CA1 to CA3 parasitic capacitance
Ls1 to Ls3, Lss1 to Lss2, Lg1 to Lg2 parasitic inductance

## Claims

1. A power semiconductor module, comprising:
at least one first circuit board (100) which is configured by a plurality of semiconductor device chips (11-16; 21-24) including at least one switching device (11-16) and disposed in a first conductor pattern (1) formed in a main surface of a first semiconductor insulating substrate (5) and a second conductor pattern (2a) formed in a region different from the first conductor pattern on the main surface of the first semiconductor insulating substrate to be electrically insulated from the first conductor pattern; and
at least one second circuit board (71) which is configured by a third conductor pattern (8) formed on one surface of a second semiconductor insulating substrate (9) different from the first semiconductor insulating substrate, and by a fourth conductor pattern (3a) and a fifth conductor pattern (4a) formed on the other surface of the second semiconductor insulating substrate opposite to the surface on which the third conductor pattern is formed, the second circuit board being configured to insulate the third conductor pattern from the fourth conductor pattern and the fifth conductor pattern by the second semiconductor insulating substrate,
wherein the second circuit board is disposed such that the third conductor pattern of the second circuit board faces the first conductor pattern of the first circuit board,
wherein the first conductor pattern includes a first power feeding point (51, 52) at one end of the first conductor pattern to feed a potential from a first module electrode terminal of the power semiconductor module to the first conductor pattern, and is configured to connect a first electrode terminal of the at least one switching device onto the first conductor pattern,
wherein the second conductor pattern is provided near the first power feeding point, and includes a second power feeding point (53) and a third power feeding point (54) to feed a potential different from the first conductor pattern from a second module electrode terminal of the power semiconductor module to the second circuit board by at least one of the second and third power feeding points,
wherein the second conductor pattern is connected to the third conductor pattern,
wherein the third conductor pattern is connected to a second electrode terminal of the at least one switching device,
wherein the fourth conductor pattern is connected to the second electrode terminal of the at least one switching device and includes a fourth power feeding point to feed a potential from a third module electrode terminal of the power semiconductor module to the fourth conductor pattern,
wherein the fifth conductor pattern is connected to a third electrode terminal of the at least one switching device and includes a fifth power feeding point to feed a potential from a fourth module electrode terminal of the power semiconductor module to the fifth conductor pattern,
wherein the fourth and fifth conductor patterns are shaped such as to extend in the same longitudinal direction such that currents (13a, 14a) flowing in them flow in this longitudinal direction,
wherein the second circuit board includes a slit pattern (81) formed in the third conductor pattern, the slit pattern (81) consisting of a plurality of slit holes arranged in parallel in the longitudinal direction of the fourth and fifth conductor patterns and arranged in a region corresponding to a projection of the fourth and fifth conductor patterns on the third conductor pattern (8), and
wherein the longitudinal direction of each of the plurality of slit holes of the slit pattern is orthogonal to the longitudinal direction of the fourth and fifth conductor patterns, such that the direction of any current (I8e) flowing in the third conductor pattern near the currents flowing in the fourth and fifth conductor patterns is orthogonal to the direction of the currents flowing in the fourth and fifth conductor patterns.

2. The power semiconductor module according to claim 1,
wherein the fourth conductor pattern (3a) and the fifth conductor pattern (4a) are configured by a plurality of sides which are orthogonal to each other, and
the longitudinal direction of each side of the fourth conductor pattern and the longitudinal direction of each side of the fifth conductor pattern are in parallel to each other, and are orthogonal to the longitudinal direction of the plurality of slit holes of the slit pattern (81) formed on the third conductor pattern (8).

3. The power semiconductor module according to claim 2,
wherein a longitudinal direction of the second circuit board (71) is the same direction as an extending direction of a longest side among the sides of the fourth conductor pattern (3a) and the sides of the fifth conductor pattern (4a), and
the longitudinal direction of the second circuit board is a direction orthogonal to a direction where a majority of current flows in the first conductor pattern (1).

4. The power semiconductor module according to any one of claims 1 to 3,
wherein the plurality of semiconductor device chips (11-16; 21-24) further include at least one diode device (21-24),
a first electrode terminal of the at least one diode device is connected onto the first conductor pattern (1), and
a second electrode terminal of the at least one diode device is connected onto the third conductor pattern (8).

5. The power semiconductor module according to claim 4,
wherein the first electrode terminal of the at least one switching device (11-16) is a drain electrode or a collector electrode,
the second electrode terminal of the at least one switching device is a source electrode or an emitter electrode,
the third electrode terminal of the at least one switching device is a gate electrode,
the first electrode terminal of the at least one diode device is a cathode electrode, and
the second electrode terminal of the at least one diode device is an anode electrode.

6. The power semiconductor module according to claim 4 or 5,
wherein the third conductor pattern (8) of the second circuit board (71) is connected to the second electrode terminal of the at least one switching device (11-16) and the second electrode terminal of the at least one diode device (21-24) by soldering.

7. The power semiconductor module according to any one of claims 1 to 6,
wherein the fourth conductor pattern (3a) of the second circuit board (71) is connected to the third electrode terminal of the at least one switching device (11-16) by wire bonding, and
the fifth conductor pattern (4a) of the second circuit board is connected to the second electrode terminal of the at least one switching device by wire bonding.

8. The power semiconductor module according to any one of claims 1 to 7,
wherein the third conductor pattern (8) and the third power feeding point (53) of the second conductor pattern (2a) are connected by a bonding wire.

9. The power semiconductor module according to claim 8,
wherein a dummy semiconductor chip is disposed near a connection point of the bonding wire on the third conductor pattern (8) to insulate the third conductor pattern and the first conductor pattern (1) from each other.

10. The power semiconductor module according to any one of claims 1 to 9,
wherein the fourth conductor pattern (3a) and the third module electrode terminal are connected to each other by a bonding wire, and
the fifth conductor pattern (4a) and the fourth module electrode terminal are connected to each other by a bonding wire.

## Patentansprüche

1. Leistungshalbleitermodul, umfassend:
mindestens eine erste Schaltplatine (100), die von mehreren Halbleitervorrichtungschips (11-16; 21-24) gebildet ist, die mindestens eine Schaltvorrichtung (11-16) enthalten und in einem in einer Hauptfläche eines ersten Halbleiterisoliersubstrats (5) gebildeten ersten Leitermuster (1) und einem in einem vom ersten Leitermuster verschiedenen Bereich auf der Hauptfläche des ersten Halbleiterisoliersubstrats gebildeten zweiten Leitermuster (2a), das vom ersten Leitermuster elektrisch isoliert zu sein hat, angeordnet sind; und
mindestens eine zweite Schaltplatine (71), die von einem dritten Leitermuster (8), das auf einer Oberfläche eines vom ersten Halbleiterisoliersubstrat verschiedenen zweiten Halbleitersubstrats (9) ausgebildet ist, und von einem vierten Leitermuster (3a) und einem fünften Leitermuster (4a), die auf der anderen Oberfläche des zweiten Halbleiterisoliersubstrats gegenüber der Oberfläche, auf der das dritte Leitermuster ausgebildet ist, ausgebildet sind, gebildet ist, wobei die zweite Schaltplatine dazu eingerichtet ist, das dritte Leitermuster von dem vierten Leitermuster und dem fünften Leitermuster durch das zweite Halbleiterisoliersubstrat zu isolieren,
wobei die zweite Schaltplatine so angeordnet ist, dass das dritte Leitermuster der zweiten Schaltplatine dem ersten Leitermuster der ersten Schaltplatine zugewandt ist,
wobei das erste Leitermuster einen ersten Stromzufuhrpunkt (51, 52) an einem Ende des ersten Leitermusters zum Zuführen eines Potenzials von einem ersten Modulelektrodenanschluss des Leistungshalbleitermoduls zum ersten Leitermuster enthält und dazu eingerichtet ist, einen ersten Elektrodenanschluss der mindestens einen Schaltvorrichtung auf das erste Leitermuster zu verbinden,
wobei das zweite Leitermuster nahe dem ersten Stromzufuhrpunkt vorgesehen ist und einen zweiten Stromzufuhrpunkt (53) und einen dritten Stromzufuhrpunkt (54) zum Zuführen eines vom ersten Leitermuster verschiedenen Potenzials von einem zweiten Modulelektrodenanschluss des Leistungshalbleitermoduls zur zweiten Schaltplatine über mindestens einen des zweiten und des dritten Stromzufuhrpunkts zuzuführen,
wobei das zweite Leitermuster mit dem dritten Leitermuster verbunden ist,
wobei das dritte Leitermuster mit einem zweiten Elektrodenanschluss der mindestens einen Schaltvorrichtung verbunden ist,
wobei das vierte Leitermuster mit dem zweiten Elektrodenanschluss der mindestens einen Schaltvorrichtung verbunden ist und einen vierten Stromzufuhrpunkt zum Zuführen eines Potenzials von einem dritten Modulelektrodenanschluss des Leistungshalbleitermoduls zum vierten Leitermuster enthält,
wobei das fünfte Leitermuster mit einem dritten Elektrodenanschluss der mindestens einen Schaltvorrichtung verbunden ist und einem fünften Stromzufuhrpunkt zum Zuführen eines Potenzials von einem vierten Modulelektrodenanschluss des Leistungshalbleitermoduls zum fünften Leitermuster enthält,
wobei das vierte und das fünfte Leitermuster so geformt sind, dass sie in der gleichen Längsrichtung verlaufen, so dass in ihnen fließende Ströme (I3a, I4a) in dieser Längsrichtung fließen,
wobei die zweite Schaltplatine ein im dritten Leitermuster ausgebildetes Schlitzmuster (81) enthält, wobei das Schlitzmuster (81) aus mehreren Schlitzlöchern besteht, die parallel in der Längsrichtung des vierten und des fünften Leitermusters angeordnet sind und in einem Bereich, der einem Vorsprung des vierten und des fünften Leitermusters auf dem dritten Leitermuster (8) entspricht, angeordnet sind, und
wobei die Längsrichtung jedes der mehreren Schlitzlöcher des Schlitzmusters orthogonal zur Längsrichtung des vierten und des fünften Leitermusters ist, so dass die Richtung jeglichen Stroms (I8e), die im dritten Leitermuster nahe den in dem vierten und dem fünften Leitermuster fließenden Strömen fließt, orthogonal zur Richtung der in dem vierten und dem fünften Leitermuster fließenden Ströme ist.

2. Leistungshalbleitermodul nach Anspruch 1,
wobei das vierte Leitermuster (3a) und das fünfte Leitermuster (4a) von mehreren Seiten gebildet sind, die orthogonal zueinander sind, und
die Längsrichtung jeder Seite des vierten Leitermusters und die Längsrichtung jeder Seite des fünften Leitermusters parallel zueinander sind und orthogonal zur Längsrichtung der mehreren Schlitzlöcher des auf dem dritten Leitermuster (8) gebildeten Schlitzmusters (81) sind.

3. Leistungshalbleitermodul nach Anspruch 2,
wobei eine Längsrichtung der zweiten Schaltplatine (71) die gleiche Richtung ist wie eine Verlängerungsrichtung einer längsten Seite unter den Seiten des vierten Leitermusters (3a) und den Seiten des fünften Leitermusters (4a), und
die Längsrichtung der zweiten Schaltplatine eine Richtung ist, die orthogonal zu einer Richtung ist, bei der eine Mehrheit von Strömen im ersten Leitermuster (1) fließt.

4. Leistungshalbleitermodul nach einem der Ansprüche 1 bis 3,
wobei die mehreren Halbleitervorrichtungschips (11-16; 21-24) ferner mindestens eine Diodenvorrichtung (21-24) enthalten,
ein erster Elektrodenanschluss der mindestens einen Diodenvorrichtung auf das erste Leitermuster (1) verbunden ist und
ein zweiter Elektrodenanschluss der mindestens einen Diodenvorrichtung auf das dritte Leitermuster (8) verbunden ist.

5. Leistungshalbleitermodul nach Anspruch 4,
wobei der erste Elektrodenanschluss der mindestens einen Schaltvorrichtung (11-16) eine Drain-Elektrode oder eine Kollektor-Elektrode ist,
der zweite Elektrodenanschluss der mindestens einen Schaltvorrichtung eine Source-Elektrode oder eine Emitter-Elektrode ist,
der dritte Elektrodenanschluss der mindestens einen Schaltvorrichtung eine Gate-Elektrode ist,
der erste Elektrodenanschluss der mindestens einen Diodenvorrichtung eine Kathodenelektrode ist und
der zweite Elektrodenanschluss der mindestens einen Diodenvorrichtung eine Anodenelektrode ist.

6. Leistungshalbleitermodul nach Anspruch 4 oder 5,
wobei das dritte Leitermuster (8) der zweiten Schaltplatine (71) mit dem zweiten Elektrodenanschluss der mindestens einen Schaltvorrichtung (11-16) und dem zweiten Elektrodenanschluss der mindestens einen Diodenvorrichtung (21-24) durch Löten verbunden ist.

7. Leistungshalbleitermodul nach einem der Ansprüche 1 bis 6,
wobei das vierte Leitermuster (3a) der zweiten Schaltplatine (71) mit dem dritten Elektrodenanschluss der mindestens einen Schaltvorrichtung (11-16) durch Drahtbonden verbunden ist und
das fünfte Leitermuster (4a) der zweiten Schaltplatine mit dem zweiten Elektrodenanschluss der mindestens einen Schaltvorrichtung durch Drahtbonden verbunden ist.

8. Leistungshalbleitermodul nach einem der Ansprüche 1 bis 7,
wobei das dritte Leitermuster (8) und der dritte Stromzufuhrpunkt (53) des zweiten Leitermusters (2a) über einen Bondingdraht verbunden sind.

9. Leistungshalbleitermodul nach Anspruch 8,
wobei ein Dummy-Halbleiterchip nahe einem Verbindungspunkt des Bondingdrahts auf dem dritten Leitermuster (8) angeordnet ist, um das dritte Leitermuster und das erste Leitermuster (1) voneinander zu isolieren.

10. Leistungshalbleitermodul nach einem der Ansprüche 1 bis 9,
wobei das vierte Leitermuster (3a) und der dritte Modulelektrodenanschluss miteinander über einen Bondingdraht verbunden sind und
das fünfte Leitermuster (4a) und der vierte Modulelektrodenanschluss miteinander über einen Bondingdraht verbunden sind.

## Revendications

1. Module à semi-conducteur de puissance, comprenant :
au moins une première carte de circuit (100) qui est configurée par une pluralité de puces de dispositifs à semi-conducteur (11-16 ; 21-24) incluant au moins un dispositif de commutation (11-16) et disposée dans un premier tracé conducteur (1) formé dans une surface principale d'un premier substrat d'isolation de semi-conducteur (5) et un deuxième tracé conducteur (2a) formé dans une région différente du premier tracé conducteur sur la surface principale du premier substrat d'isolation de semi-conducteur pour être électriquement isolé du premier tracé conducteur ; et
au moins une deuxième carte de circuit (71) qui est configurée par un troisième tracé conducteur (8) formé sur une surface d'un deuxième substrat d'isolation de semi-conducteur (9) différent du premier substrat d'isolation de semi-conducteur, et par un quatrième tracé conducteur (3a) et un cinquième tracé conducteur (4a) formés sur l'autre surface du deuxième substrat d'isolation de semi-conducteur opposée à la surface sur laquelle le troisième tracé conducteur est formé, la deuxième carte de circuit étant configurée pour isoler le troisième tracé conducteur du quatrième tracé conducteur et du cinquième tracé conducteur par le deuxième substrat d'isolation de semi-conducteur,
dans lequel la deuxième carte de circuit est disposée de telle manière que le troisième tracé conducteur de la deuxième carte de circuit fait face au premier tracé conducteur de la première carte de circuit,
dans lequel le premier tracé conducteur inclut un premier point d'alimentation en énergie (51, 52) à une extrémité du premier tracé conducteur pour alimenter un potentiel provenant d'une première borne d'électrode de module du module à semi-conducteur de puissance jusqu'au premier tracé conducteur, et est configuré pour connecter une première borne d'électrode de l'au moins un dispositif de commutation sur le premier tracé conducteur,
dans lequel le deuxième tracé conducteur est prévu à côté du premier point d'alimentation en énergie, et inclut un deuxième point d'alimentation en énergie (53) et un troisième point d'alimentation en énergie (54) pour alimenter un potentiel différent du premier tracé conducteur d'une deuxième borne d'électrode de module du module à semi-conducteur de puissance jusqu'à la deuxième carte de circuit par au moins un des deuxième et troisième points d'alimentation en énergie,
dans lequel le deuxième tracé conducteur est connecté au troisième tracé conducteur,
dans lequel le troisième tracé conducteur est connecté à une deuxième borne d'électrode de l'au moins un dispositif de commutation,
dans lequel le quatrième tracé conducteur est connecté à la deuxième borne d'électrode de l'au moins un dispositif de commutation et inclut un quatrième point d'alimentation en énergie pour alimenter un potentiel d'une troisième borne d'électrode de module du module à semi-conducteur de puissance jusqu'au quatrième tracé conducteur,
dans lequel le cinquième tracé conducteur est connecté à une troisième borne d'électrode de l'au moins un dispositif de commutation et inclut un cinquième point d'alimentation en énergie pour alimenter un potentiel d'une quatrième borne d'électrode de module du module à semi-conducteur de puissance jusqu'au cinquième tracé conducteur,
dans lequel les quatrième et cinquième tracés conducteurs sont formés de manière à s'étendre dans le même sens longitudinal de telle façon que des courants (I3a, I4a) passant par ceux-ci passent dans ce sens longitudinal,
dans lequel la deuxième carte de circuit inclut un tracé de fente (81) formé dans le troisième tracé conducteur, le tracé de fente (81) consistant en une pluralité de trous de fente agencés en parallèle dans le sens longitudinal des quatrième et cinquième tracés conducteurs et agencés dans une région correspondant à une projection des quatrième et cinquième tracés conducteurs sur le troisième tracé conducteur (8), et
dans lequel le sens longitudinal de chacun de la pluralité de trous de fente du tracé de fente est orthogonal au sens longitudinal des quatrième et cinquième tracés conducteurs, de telle manière que le sens d'un courant quelconque (I8e) passant dans le troisième tracé conducteur à côté des courants passant dans les quatrième et cinquième tracés conducteurs est orthogonal au sens des courants passant dans les quatrième et cinquième tracés conducteurs.

2. Module à semi-conducteur de puissance selon la revendication 1,
dans lequel le quatrième tracé conducteur (3a) et le cinquième tracé conducteur (4a) sont configurés par une pluralité de côtés qui sont orthogonaux les uns aux autres, et
le sens longitudinal de chaque côté du quatrième tracé conducteur et le sens longitudinal de chaque côté du cinquième tracé conducteur sont en parallèle l'un à l'autre, et sont orthogonaux au sens longitudinal de la pluralité de trous de fente du tracé de fente (81) formés sur le troisième tracé conducteur (8).

3. Module à semi-conducteur de puissance selon la revendication 2,
dans lequel un sens longitudinal de la deuxième carte de circuit (71) est le même sens qu'un sens d'extension d'un côté le plus long parmi les côtés du quatrième tracé conducteur (3a) et les côtés du cinquième tracé conducteur (4a), et
le sens longitudinal de la deuxième carte de circuit est un sens orthogonal à un sens où un majorité de courant passe dans le premier tracé conducteur (1).

4. Module à semi-conducteur de puissance selon l'une quelconque des revendications 1 à 3,
dans lequel la pluralité de puces de dispositifs à semi-conducteur (11-16 ; 21-24) inclut en outre au moins un dispositif à diodes (21-24),
une première borne d'électrode de l'au moins un dispositif à diodes est connectée sur le premier tracé conducteur (1), et
une deuxième borne d'électrode de l'au moins un dispositif à diodes est connectée sur le troisième tracé conducteur (8).

5. Module à semi-conducteur de puissance selon la revendication 4,
dans lequel la première borne d'électrode de l'au moins un dispositif de commutation (11-16) est une électrode de drain ou une électrode de collecteur,
la deuxième borne d'électrode de l'au moins un dispositif de commutation est une électrode de source ou une électrode d'émetteur,
la troisième borne d'électrode de l'au moins un dispositif de commutation est une électrode de grille,
la première borne d'électrode de l'au moins un dispositif à diodes est une électrode de cathode, et
la deuxième borne d'électrode de l'au moins un dispositif à diodes est une électrode d'anode.

6. Module à semi-conducteur de puissance selon la revendication 4 ou 5,
dans lequel le troisième tracé conducteur (8) de la deuxième carte de circuit (71) est connecté à la deuxième borne d'électrode de l'au moins un dispositif de commutation (11-16) et à la deuxième borne d'électrode de l'au moins un dispositif à diodes (21-24) par brasage.

7. Module à semi-conducteur de puissance selon l'une quelconque des revendications 1 à 6,
dans lequel le quatrième tracé conducteur (3a) de la deuxième carte de circuit (71) est connecté à la troisième borne d'électrode de l'au moins un dispositif de commutation (11-16) par liaison par fils, et
le cinquième tracé conducteur (4a) de la deuxième carte de circuit est connecté à la deuxième borne d'électrode de l'au moins un dispositif de commutation par liaison par fils.

8. Module à semi-conducteur de puissance selon l'une quelconque des revendications 1 à 7,
dans lequel le troisième tracé conducteur (8) et le troisième point d'alimentation en énergie (53) du deuxième tracé conducteur (2a) sont connectés par un fil de liaison.

9. Module à semi-conducteur de puissance selon la revendication 8,
dans lequel une puce à semi-conducteur factice est disposée à côté d'un point de connexion du fil de liaison sur le troisième tracé conducteur (8) pour isoler le troisième tracé conducteur et le premier tracé conducteur (1) l'un de l'autre.

10. Module à semi-conducteur de puissance selon l'une quelconque des revendications 1 à 9,
dans lequel le quatrième tracé conducteur (4a) et la troisième borne d'électrode de module sont connectés l'un à l'autre par un fil de liaison, et
le cinquième tracé conducteur (4a) et la quatrième borne d'électrode de module sont connectés l'un à l'autre par un fil de liaison.
